# EUROPEAN PATENT SPECIFICATION

(11) **EP 0 360 272 B1**
(45) Date of publication and mention of the grant of the patent: **01.12.1993**
(21) Application number: 89117492.2
(22) Date of filing: 21.09.1989
(51) Int. Cl.: G03F 7/20

(54) **Stepper for circuit pattern formation**
Sequenzvorrichtung zur Bildung von Schaltkreisen
Dispositif de séquence pour la formation de circuits intégrés

(30) Priority: 22.09.1988 JP 237807/88; 19.10.1988 JP 263184/88
(43) Date of publication of application: 28.03.1990
(73) Proprietor: FUJITSU LIMITED, Kawasaki-shi, Kanagawa 211 (JP)
(72) Inventor: Tabata, Fumio c/o FUJITSU LIMITED, Kawasaki-shi Kanagawa 211 (JP); Sekiguchi, Hidenori c/o FUJITSU LIMITED, Kawasaki-shi Kanagawa 211 (JP); Kamada, Toru c/o FUJITSU LIMITED, Kawasaki-shi Kanagawa 211 (JP); Sakata, Yuji c/o FUJITSU LIMITED, Kawasaki-shi Kanagawa 211 (JP)
(74) Representative: Sunderland, James Harry

(56) References cited:
- EP-A- 0 253 349
- NUCLEAR INSTRUMENTS & METHODS IN PHYSICS RESEARCH, SECTION - A vol. A246, no. 1/3, May 1986, AMSTERDAM, NL pages 658-667; H. Betz: "HIGH RESOLUTION LITHGRAPHY SYNCHROTRON RADIATION"
- MICROELECTRONIC ENGINEERING. vol. 6, no. 1-4, December 1987, AMSTERDAM NL pages 293 - 297; P.Thompson et al.: "A SYNCHROTRON COMPATIBLE PRODUCTION ORIENTED X-RAY STEPPER"

## Description

The present invention relates to a stepper for circuit pattern formation. It is particularly, but not exclusively, concerned with a vertical stepper. Such a stepper is employed for example in a process of transferring a circuit pattern formed on a mask, which process uses synchrotron radiation (hereinafter simply referred to as "SR") as a light source.

In recent years, attention has been given to an X-ray exposure method as a means for manufacturing 16M bit or more VLSI circuit patterns, which method employs SR as a light source. This exposure method has desirable features in that the wavelength of the light source (the term "light source" is used here to refer generally to sources of radiation for exposure, and does not necessarily refer to visible light) is short and the light source has good parallel properties, as compared with a conventional exposure method in which ultraviolet light is used. Not only is this X-ray method suitable for transfer of submicron patterns, but also a high throughput can be expected because of the comparatively great strength of the SR.

A horizontal stepper (reduced projection exposure device) is an example of a conventional VLSI exposure device, for use with ultraviolet. This horizontal stepper is designed such that a wafer and a mask are horizontally disposed at a predetermined space. An ultraviolet ray is irradiated from a light source disposed above the mask and wafer, in order to transfer a circuit pattern formed on the mask on to the wafer (with a reduced scale on the wafer). However, such ultraviolet ray exposure type equipment has a disadvantage in that the wavelength of the ultraviolet light is too long to be suitable for the exposure of a submicron circuit pattern. This is the reason why the above-mentioned X-ray exposure method using SR as a light source has drawn attention as means for VLSI manufacture on a scale of 16M bits or more.

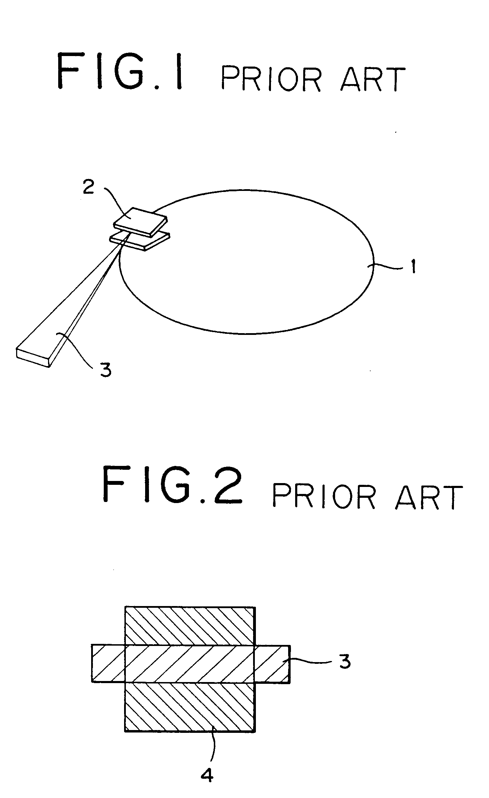

Fig. 1 is a diagram schematically illustrating the principle of SR generation. Electrons accelerated by an accelerator (not shown) and made incident to a vacuum storage ring 1 are circulated within the ring 1 while being bent in their orbit by a deflection magnet 2. Beam-like SR 3 is irradiated in a direction tangential to the portion of the orbit where the orbit is bent by the deflection magnet 2. Though this SR includes a wide range of wavelengths of electromagnetic waves (e.g. from ultraviolet to X-ray) X-rays over predetermined range of wavelengths are obtained by cutting electromagnetic waves of other wavelengths by using mirrors, a Be-window, etc. (not shown), and the thus obtained X-rays are used for exposure.

Incidentally, in order to generate SR, it is necessary for electrons to be accelerated from approximately several hundred MeV to approximately several GeV. In order to meet this requirement, an SR generator is large and therefore must, in practice, be horizontally installed. Since SR is then irradiated in a horizontal direction, a stepper involved when using SR for exposure is necessarily of a vertical type, wherein the mask and the wafer are vertically oriented.

Also, beam-like SR 3 has a rectangular shape, in section, which shape is elongated in the horizontal direction, as shown in Fig. 2. therefore, as a single scanning is not enough to cover the whole exposure area of a mask 4, it is necessary to perform a vertical scanning operation, wherein mask and the wafer are integrally moved in vertical directions during the course of exposure. Furthermore, the whole surface of the wafer must be exposed by moving the wafer in a step-and-repeat fashion, in generally the same manner as in a conventional horizontal stepper with which visible light, ultraviolet light, etc., are used as light source.

Nuclear Instruments and Methods in Physics Research, Section A, Vol. A246 (1986) May, No. 1/3, Amsterdam. Netherlands, pages 658 to 667, discloses a stepper for transferring a circuit pattern formed on a mask on to a wafer by means of exposure to radiation from a light source, for instance synchrotron radiation, said stepper comprising:-
a coarse X-Y stage for moving the wafer in a plane perpendicular to the direction of irradiation of said radiation;
a mask stage for mounting the mask thereon in such a manner that the mask is oriented perpendicularly to the direction of irradiation of said radiation;
a wafer mounting member for mounting the wafer thereon in such a manner that the wafer is oriented perpendicularly to the direction of irradiation of said radiation, said wafer mounting member including fine X-Y positioning means.

Microelectronic Engineering, Vol. 6 (1987), pages 293 to 297, discloses a stepper with scanning means for scanning the mask stage.

According to the present invention there is provided a stepper for transferring a circuit pattern formed on a mask on to a wafer by means of exposure to radiation from a light source, for instance synchrotron radiation, said stepper comprising:-
a coarse X-Y stage for moving the wafer in a plane perpendicular to the direction of irradiation of said radiation;
a mask stage for mounting the mask thereon in such a manner that the mask is oriented perpendicularly to the direction of irradiation of said radiation;
a wafer mounting member for mounting the wafer thereon in such a manner that the wafer is oriented perpendicularly to the direction of irradiation of said radiation, said wafer mounting member including fine X-Y positioning means;
characterised in that
the mask stage is adapted to be moved for scanning in a direction perpendicular to the direction of irradiation of said radiation;
the wafer mounting member is movable between a first position, mounted on said coarse X-Y stage, and a second position, mounted on said mask stage, and said fine X-Y positioning means is a fine X-Y positioning stage;
and in that the stepper further comprises
scanning means for scanning said mask stage;
transfer means for moving said wafer mounting member between said first and second positions;
first attracting means for attracting said wafer to said wafer mounting member; and
second attracting means for attracting said wafer mounting member to said mask stage;
and in that
said mask stage includes a fine Z-ϑ stage for moving the mask in the direction of irradiation of said radiation and rotating the mask in a plane perpendicular to the direction of irradiation of said radiation.

According to the present invention there is provided a stepper for transferring a circuit pattern formed on a mask on to a wafer by means of exposure to radiation from a light source, for instance synchrotron radiation, said stepper comprising:-
a coarse X-Y stage for moving the wafer stepwise in a plane perpendicular to the direction of irradiation of said radiation;
fine X-Y positioning means mounted on the coarse X-Y stage for moving the wafer in a plane perpendicular to the direction of irradiation of said radiation;
a mask stage for mounting the mask thereon in such a manner that the mask is oriented perpendicularly to the direction of irradiation of said radiation;
characterised in that
the mask stage is adapted to be moved for scanning in a direction perpendicular to the direction of irradiation of said radiation;
the fine X-Y positioning means comprise a fine X-Y stage having a fine X-axis stage including a fine X-axis member movable in the X-axis direction, first parallel plate spring guides for supporting said fine X-axis member, and a first piezoelectric device disposed in such a manner as to displace said fine X-axis member in the X-axis direction; and a fine Y-axis stage including a fine Y-axis member movable in the Y-axis direction, second parallel plate spring guides for supporting said fine Y-axis member, and a second piezoelectric device disposed in such a manner as to displace said fine Y-axis member in the Y-axis direction, said fine Y-axis stage being mounted on said fine X-axis stage;
in that the stepper further comprises
scanning means for scanning said mask stage;
and in that
said mask stage includes a fine Z-ϑ stage for moving the mask in the direction of irradiation of said radiation and rotating the mask in a plane perpendicular to the direction of irradiation of said radiation.

An embodiment of the present invention can provide a stepper, for example a vertical stepper, with which a submicron circuit pattern can be reliably transferred on to a wafer by means of exposure using for instance SR, irradiated in the horizontal direction, as light source.

An embodiment of the present invention can provide a stepper, for example a vertical stepper, in which three-dimensional relative positioning between mask and wafer can be strictly or more strictly accurately aligned and a step-and-repeat action can be performed (in a vertical plane).

An embodiment of the present invention can provide a vertical stepper in which occurrence of vertical displacement, caused by gravity, when wafer is moved in the horizontal direction with respect to mask, is prevented or reduced.

An embodiment of the present invention provides a stepper, for instance a vertical stepper, for transferring a circuit pattern formed on a mask on to a wafer, by means of exposure using synchrotron radiation as light source, the stepper comprising a coarse X-Y stage for moving the wafer steppingly or progressively in Y and X (vertical and horizontal) directions in a plane perpendicular to the direction of irradiation (Z) of the synchrotron radiation; a mask stage having the mask mounted thereon such that the mask is oriented in the perpendicular direction (in an X-Y plane) and is moved for scanning in the vertical (Y) direction; scanning means for scanning the mask stage in the vertical (Y) direction; a wafer mounting member having the wafer mounted thereon such that said wafer is oriented in the perpendicular direction (an X-Y plane) and movable in the horizontal (Z) direction between a first position mounted on said coarse X-Y stage and a second position mounted on said mask stage, said wafer mounting member including a fine X-Y stage; transfer means for moving said wafer mounting member between said first and second positions; first suction means for vacuum drawing said wafer to said wafer mounting member; and second suction means for vacuum drawing said wafer mounting member to said mask stage. The mask stage includes a fine Z-ϑ stage for moving the mask in directions parallel to the direction of irradiation of the synchrotron radiation (Z) and for rotating the mask in a plane (X-Y) vertical to the direction (Z) of the synchrotron radiation. Also, the transfer means may include a plurality of guide pins mounted on the coarse X-Y stage, and air cylinder means one end of which is attached to the coarse X-Y stage and the other end of which is attached to the wafer mounting member, the wafer mounting member being engaged with and guided by the guide pins.

The transfer means may include a transfer member, a plurality of guide pins mounted on the coarse X-Y stage and adapted to be engaged with the transfer member in order to guide the transfer member; air cylinder means one end of which is attached to the coarse X-Y stage and the other end of which is attached to the transfer member; and third suction means for selectively vacuum drawing the wafer mounting member.

The fine X-Y stage may include a fine X-axis station which is movable in the X-axis direction, and a fine Y-axis station, mounted on the fine X-axis station, and movable in Y-axis direction. The fine X-axis station includes a fine X-axis member movable in the X-axis direction, first parallel plate spring guides for supporting the fine X-axis member, and a first piezoelectric device disposed in such a manner as to displace the fine X-axis member in the X-axis direction. Similarly, the fine Y-axis station includes a fine Y-axis member movable in the Y-axis direction, second parallel plate spring guides for supporting the fine Y-axis member, and a second piezoelectric device disposed in such a manner as to displace the fine Y-axis member in the Y-axis direction.

Alternatively, the fine X-Y stage may comprise a fine X-Y member movable in X-axis and Y-axis directions; first, second, third and fourth parallel plate spring guide means for supporting the fine X-Y member; and first and second piezoelectric devices disposed in such a manner as to displace the fine X-Y member in X-axis and Y-axis directions, respectively.

Reference is made, by way of example, to the accompanying drawings, in which:-
Fig. 1 is a schematic view for assistance in explaining the principle of SR generation;
Fig. 2 is a schematic view illustrating relationship between an area of exposure and SR;
Fig. 3 is a perspective view illustrating construction of a vertical stepper according to an embodiment of the present invention;
Fig. 4 is a schematic view illustrating the positional relationships between a mask and a wafer and degrees of freedom provided for the mask and the wafer;
Fig. 5 is a perspective view of the construction of a two-stage structure, with one stage superposed on the other, according to an embodiment of the present invention, wherein a fine X-Y stage is indicated by chain lines;
Fig. 6 is a schematic view illustrating arrangement of and piping for dead-weight compensating means shown in Fig. 5;
Fig. 7 is a schematic view of a single axis stage comprising a combination of parallel plate spring guides and a piezoelectric device, according to an embodiment of the present invention;
Fig. 8 is a schematic perspective view of a two-stage structure, with one stage superposed on the other, according to an embodiment of the present invention;
Fig. 9 is a view schematically showing the construction of an X-Y axis integral-type fine X-Y stage, according to an embodiment of the present invention;
Fig. 10 is an explanatory view, assisting in explanation of the action of the structure of Fig. 9;
Fig. 11 is another explanatory view, assisting in explanation of the action of the structure of Fig. 9, when the X-Y axis integral type fine X-Y stage is displaced in X-axis and Y-axis directions simultaneously;
Fig. 12 is a perspective view, partly in section, of a mask stage according to one embodiment of the present invention;
Fig. 13 is a sectional view of the mask stage of Fig. 12;
Fig. 14 is a view similar to Fig. 13 but showing a possible operating condition of the mask stage of Fig. 12, with a piezoelectric device actuated;
Fig. 15 is a schematic view for assistance in explaining principles of operation of a measuring worm type moving mechanism which may be employed in an embodiment of the present invention;
Fig. 16 is a schematic view showing one example of a rotational mechanism of the mask stage according to an embodiment of the present invention;
Fig. 17 is a schematic perspective view of a scanning mechanism, for scanning a mask stage having a wafer integrally mounted thereon, in a vertical direction with respect to SR, according to an embodiment of the present invention;
Fig. 18 is a side view of a wafer transfer mechanism according to an embodiment of the present invention;
Fig. 19A is a front view of a wafer mounting member according to an embodiment of the present invention;
Fig. 19B is a sectional view taken along line A-A of Fig. 19A;
Fig. 20A is a front view of a transfer member according to an embodiment of the present invention;
Fig. 20B is a sectional view taken along line B-B of Fig. 20A; and
Figs. 21A to 21C are explanatory views for assistance in explaining wafer transfer steps, wherein Fig. 21A shows the wafer mounting member in a position away from the mask stage, Fig. 21B shows the wafer mounting member brought into intimate contact with the mask stage by the transfer mechanism, and Fig. 21C shows the wafer mounting member drawn or attracted to the mask stage and the transfer member returned to its original position.

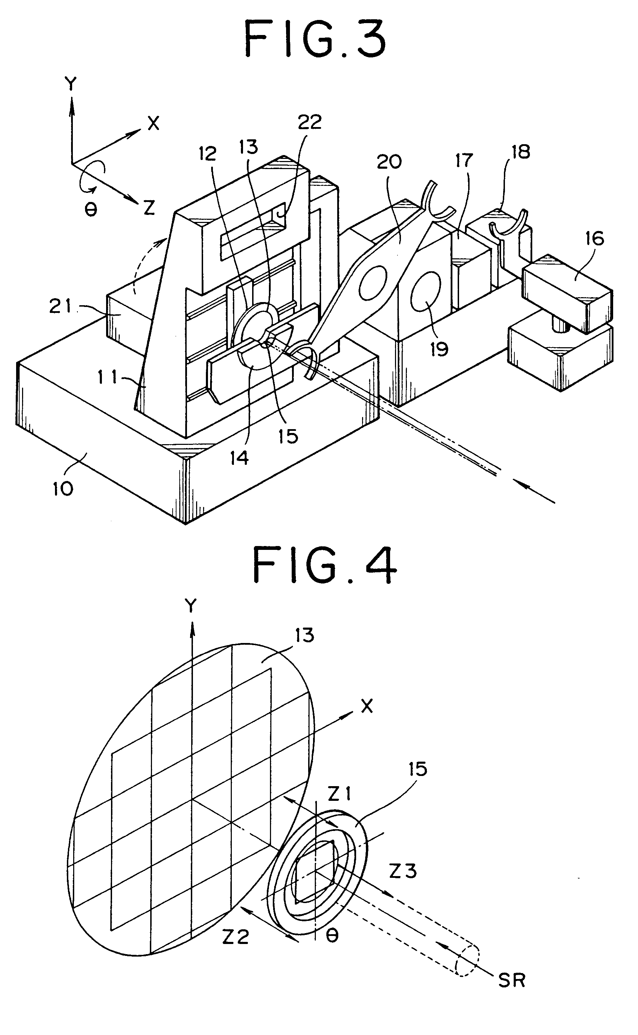

Referring first to Fig. 3, a vertical stepper according to one embodiment of the present invention will be described briefly. Reference number 10 denotes a vibration isolating bed on which a support or column 11 is disposed. A wafer stage 12 is mounted on the column 11. The wafer stage 12 comprises a coarse X-Y stage and a fine X-Y stage, as will be described hereinafter, and has degrees of freedom in X-axis and Y-axis directions (see Fig. 3). The wafer stage 12 carries a wafer 13 and has a step-and-repeat function for effecting a transfer of a circuit pattern on to the whole wafer surface by means of exposure. With respect to the degree of freedom which relates to a vertical plane, the wafer stage 12 includes a dead-weight compensating mechanism as will be described hereinafter for offsetting its dead-weight so that the dead-weight of the wafer stage does not become a load to be carried by an actuator.

Reference numeral 14 denotes a mask stage which carries a mask 15 having a circuit pattern formed thereon and which has a degree of freedom in a Z-axis direction of Fig. 4 (that is, is capable of parallel displacement in a Z-axis direction, rotation about an X-axis, and rotation about a Y-axis) in order to provide for control of spacing between the mask stage 14 and the wafer 13 and the relative posture of the stage 14, and also has a degree of freedom for correcting relative rotational displacement with respect to the wafer 13 (that is, a degree of freedom in the ϑ-axis rotational direction). Further, the mask stage 14 includes a Y-axis direction SR beam-scanning mechanism for moving the mask stage 14 in the vertical direction by fixing the relative position between the mask 14 and the wafer 13, by means of a method as will be described hereinafter, in order to provide SR irradiation over the whole surface of the mask 14 when the SR beam is of rectangular shape in section as shown in Fig. 2. This mask stage 14 is also provided with a dead-weight compensating mechanism adapted to offset the dead-weight of the mask stage during scanning movement.

Reference numeral 16 denotes a wafer loader which is a device for transferring a wafer 13 before exposure, stocked in a wafer stocker 17, to a prealignment stage 19 by means of remote control. Reference numeral 18 denotes a wafer stocker for stocking a wafer after exposure. The prealignment stage 19 is a stage for automatically roughly performing an alignment of the wafer before the wafer 13 is mounted on the wafer stage 12 and has three degrees of freedom in X-axis, Y-axis and ϑ-axis directions.

Reference numeral 20 denotes another wafer loader which is an arm-type rotational mechanism capable of transferring a wafer, which has been roughly aligned by the prealignment stage 19, to the wafer stage 12 by means of remote control. Reference numeral 21 denotes a mask loader which is a device for transferring a mask selected from a plurality of masks stocked in a mask magazine (not shown) to the mask stage 14 with the stage lifted up to an uppermost position, via an opening portion 22 formed in an upper portion of the column 11 by means of remote control.

Operation of the above-mentioned vertical stepper will be described briefly. A wafer 13, which has not yet been subjected to exposure processing, is taken out of the wafer stocker 17 by the wafer loader 16 and such taken-out wafer 13 is vacuum-attracted or drawn on to the prealignment stage 19. After roughly aligning the wafer at this prealignment stage 19 by means of a method using image processing or a photoelectric transducer such as a laser diode or the like, the wafer is transferred to the wafer stage 12 by the wafer loader 20 and the wafer 13 is vacuum-attracted to the wafer stage 12. At this time, the mask stage 14 is retreated to an upper position. Then, the wafer stage 12 is moved to an exposure position, and the mask stage 14 is lowered until it is brought into opposition to the wafer stage 12. After the relative positions of wafer 13 and mask 15 have been strictly accurately aligned, SR is irradiated in order to transfer the circuit pattern formed on the mask 15 on to the wafer 13 by means of exposure. The wafer stage 12 is steppingly moved in the X-axis and Y-axis directions to repeat the above-mentioned circuit pattern transfer operation. That is, by performing step-and-repeat operation, the circuit pattern formed on the mask is transferred on to the whole surface of the wafer 13 by means of exposure. The wafer 13, which has been subjected to the exposure processing, is transferred to the wafer stocker 18 by the wafer loader 20 and stocked therein. Thus, exposure of a wafer sheet is completed.

In order to mount the mask 15 on the mask stage 14, the mask loader 21 withdraws a required mask from the mask magazine (not shown) and transfers it to the mask stage 14, which has been brought to its upper portion, via the opening portion 22 as indicated by a broken-line arrow. Then, after the mask stage 14 is lowered and correctly positioned, the mask 15 is fixed on to the mask stage 14 by means of vacuum suction.

Now, component parts constituting the above-described vertical stepper will be described in more detail hereinbelow.

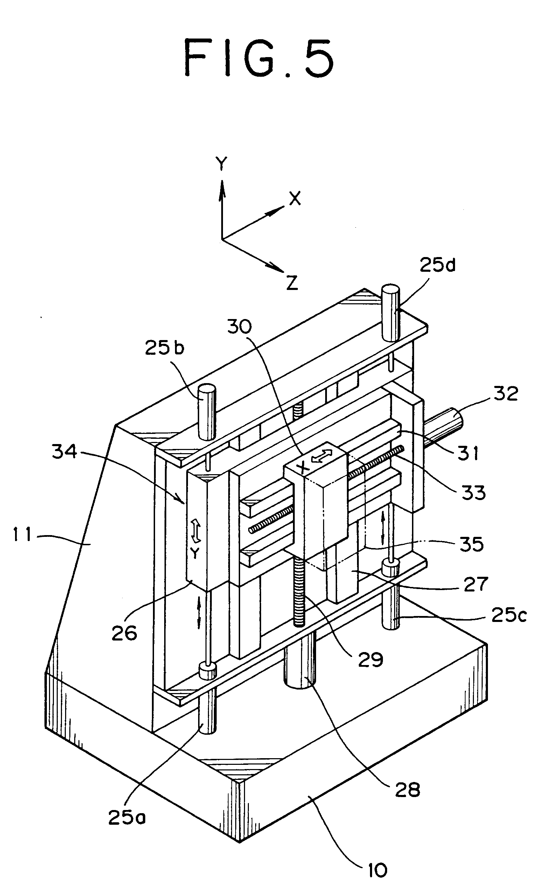

First, referring to Fig. 5, there will be described a wafer stage comprising a coarse X-Y stage and a fine X-Y stage superposed one upon the other to form a two-stage structure, and a dead-weight compensating mechanism thereof. The column 11 is provided with a Y-axis stage 26 which is guided by a pair of guide rails 27 in a vertical (Y) direction. This Y-axis stage 26 is moved in the vertical direction (Y-axis direction) by a driving mechanism comprising an actuator 28 and a ball screw 29. The Y-axis stage 26 is provided with an X-axis stage 30 which is guided in the horizontal direction (X-axis direction) by a pair of guide rails 31. The X-axis stage 30 is moved in the horizontal direction by a driving mechanism comprising an actuator 32 and a ball screw 33. Herein, a stage comprising the Y-axis stage 26 and the X-axis stage 30 is referred to as a coarse X-Y stage 34. On the coarse X-Y stage 34, a fine X-Y stage 35 as will be described below is mounted, as indicated by chain lines, to form a two-stage structure.

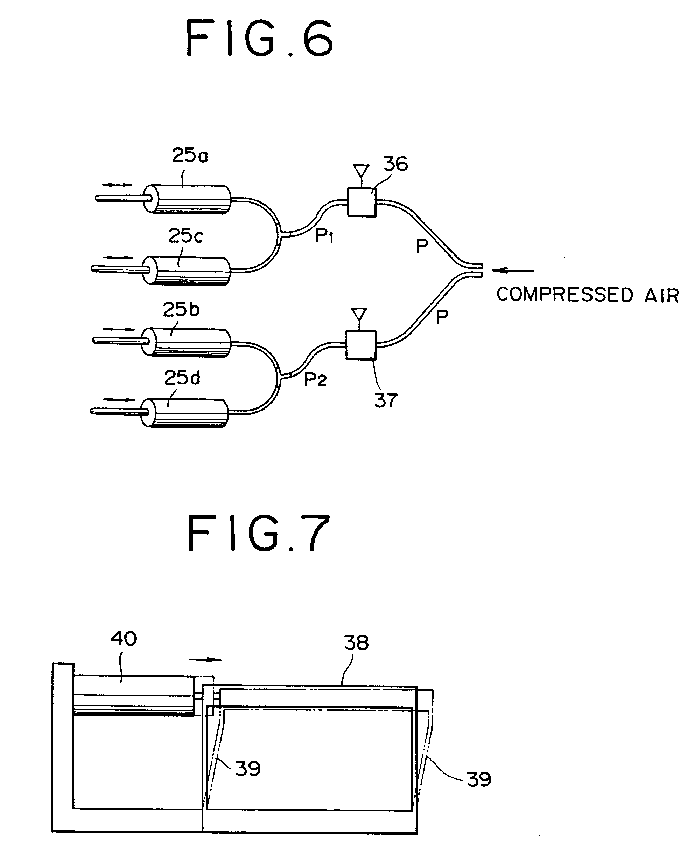

As illustrated, the coarse X-Y stage 34 is supported in such a manner as to be sandwiched by four air cylinders 25a to 25d. As shown in Fig. 6, pressure P of a compressed air supply is reduced to a pressure P1 by a pressure-reducing valve 36 and fed to the air cylinders 25a and 25c, and is reduced to a pressure P2 by a pressure-reducing valve 37 and then fed to the air cylinders 25b and 25d, respectively. The fine X-Y stage 35, as will be described, can be demounted from the coarse X-Y stage. Therefore, in a case in which the fine X-Y stage 35 is not on the coarse X-Y stage 34, a differential pressure P1-P2 between the cylinders 25a and 25b and a differential pressure P1-P2 between the cylinders 25c and 25d are set such that they are equal to a half of the dead-weight of the coarse X-Y stage 34 so that the differential pressure is not changed even if the air pressure is changed, and a stable dead-weight compensation is always achieved. Further, in a case in which the fine X-Y stage 35 is mounted on the coarse X-Y stage 34, the pressure-reducing valves 36 and 37 are controlled by a solenoid valve, etc., such that the differential pressure P1-P2 is equal to a half of the total weight of both the stages. The air cylinders 25a to 25d stabilise a servo system of the wafer stage 12 comprising the coarse X-Y stage 34 and the fine X-Y stage 35 by a damper effect of the air itself and the mass of the movable portion is not increased. Mass increase of the movable portion is a shortcoming inherent in a dead-weight compensating mechanism using a counterweight.

As the actuators 28 and 32 of the coarse X-Y stage 34, there can be employed rotary-type DC servo motors, multipolar DC motors or the like. By means of feedback control using position detectors such as rotary encoders or the like, micron order positioning can be realised. As a position detector, there may be employed a linear scale or a laser interferometer instead of a rotary encoder.

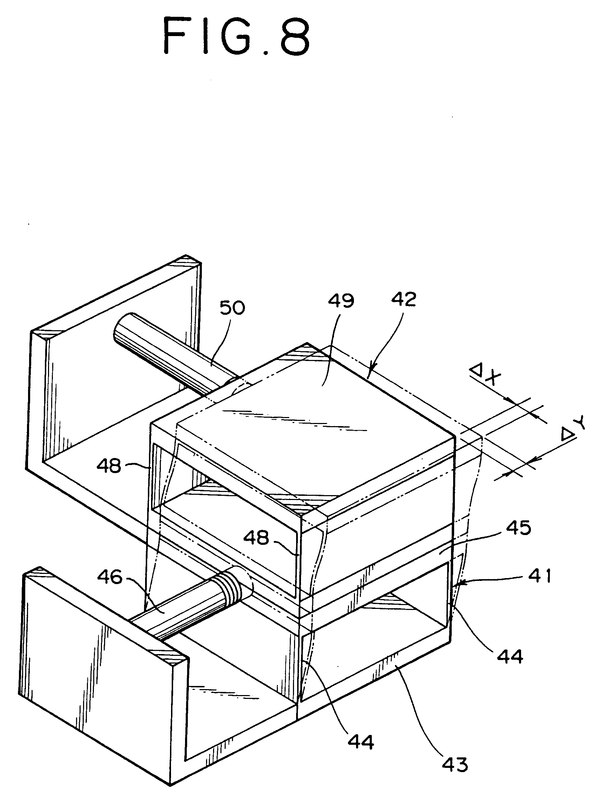

A single axis stage part of a fine X-Y stage is constructed as shown in Fig. 7, in which a movable member 38 is supported by a pair of parallel plate spring guides 39 and a piezoelectric device 40 is used as an actuator. In order to form a two-stage structure, two single axis stages are superposed one upon the other as shown in Fig. 8. That is, the fine X-Y stage 35 comprises a fine Y-axis stage 41 and a fine X-axis stage 42 which is superposed on the Y-axis stage 41. The fine Y-axis stage 41 is designed such that a fine Y-axis member 45 is supported on a fixed member 43 by a pair of parallel plate spring guides 44, and a piezoelectric device 46 is disposed in such a manner as to displace the fine Y-axis member 45 in the Y-axis direction. Similarly, the fine X-axis stage 42 is designed such that a fine X-axis member 49 is supported on the fine Z-axis member 45 by a pair of parallel spring guides 48, and a piezoelectric device 50 is disposed in such a manner as to displace the fine X-axis member 49 in the X-axis direction.

By detecting the displaced amount ΔX, ΔY of the fine X-axis and Y-axis members, using high resolution position detectors such as a laser interferometer, a differential transformer or the like, and controlling the same by feedback, submicron order positioning can be effected. Of course, the Y-axis stage may alternatively be superposed on the X-axis stage.

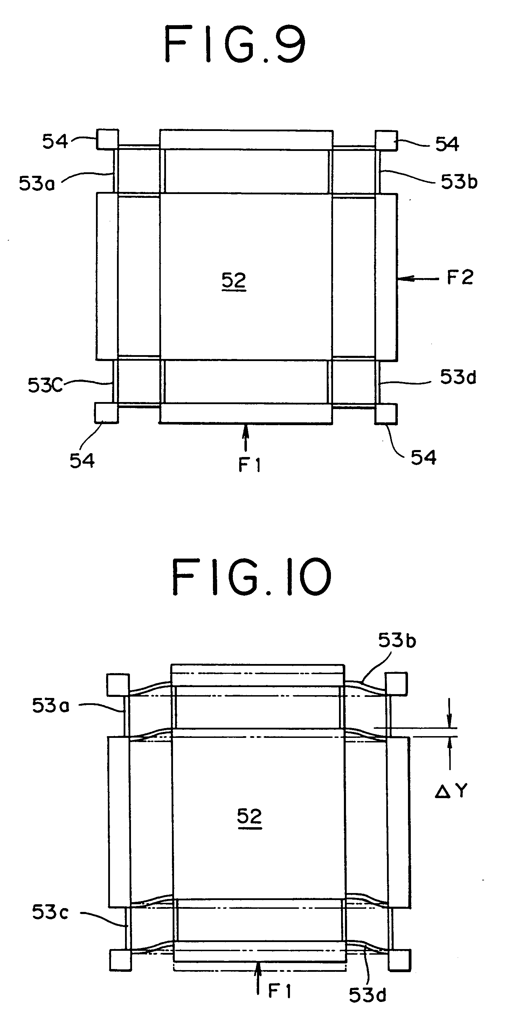

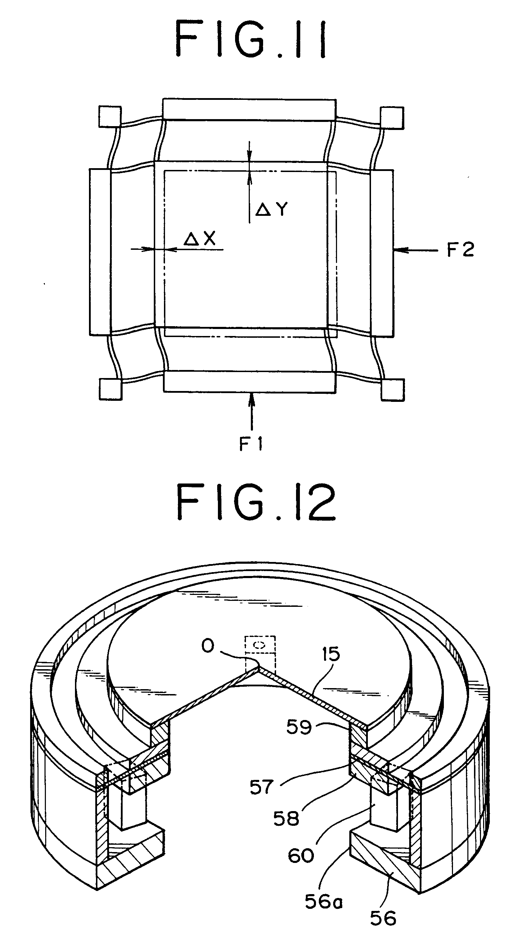

Referring to Fig. 9, there is illustrated an alternative possible structure of a fine X-Y stage which can be used in an embodiment of the invention, in which an XY-axes integral-type guide mechanism is employed. A fine X-Y member 52 movable in X-axis and Y-axis directions is supported by four parallel plate spring guiding means 53a to 53d each comprising a pair of parallel plate spring guides. A force F1 is applied to the fine X-Y member 52 by a first piezoelectric device (not shown) and a force F2 is applied thereto by a second piezoelectric device (not shown). Reference numeral 54 denotes a mounting portion of the fine X-Y stage with respect to the coarse X-Y stage or with respect to a wafer mounting member as will be described hereinafter. As shown in Fig. 10, when the force F1 is generated by the piezoelectric device, the fine X-Y member 52 is displaced by ΔY due to bending deformation of the parallel plate spring guiding means 53a to 53d. The same is applicable to displacement in the X-axis direction. When the force F1 is applied in the Y-axis direction and the force F2 is applied in the X-axis direction, the fine X-Y member 52 is displaced in the manner shown in Fig. 11.

The fine X-Y stage 35 can be separated from the coarse X-Y stage 34 so that it can be vacuum-drawn to the mask stage 14 at the time of SR exposure. By providing the wafer stage with a two-stage structure in which the coarse X-Y stage 34 and the fine X-Y stage 35 are superposed one upon the other, a high-speed step-and-repeat operation and an accurate positioning operation can be simultaneously realised.

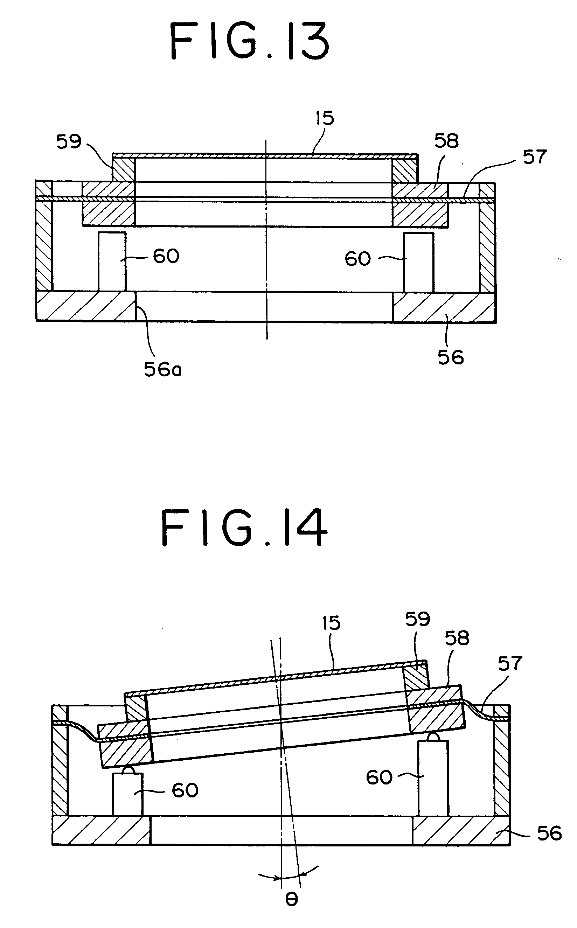

Next, referring to Figs. 12 to 14, construction of the mask stage 14 will be described. A ring-shaped movable member 58 is mounted on a fixed member 56, having a circular opening portion 56a at its centre, by way of a ring-shaped diaphragm 57. The ring-shaped movable member 58 is provided thereon with a ring-shaped mask chuck 59, and the mask 15 is drawn and fixed by this mask chuck 59. Further, the movable member 58 is provided at three places on its circumference about the centre 0 of the movable member 58 with piezoelectric devices 60, arranged with equal spacing. Through expanding and contracting motion of the piezoelectric devices 60, the distance and the relative inclination between mask and wafer can be corrected as shown in Fig. 14. In order to detect the position of the mask stage, differential transformer or a linear scale may be used, for example.

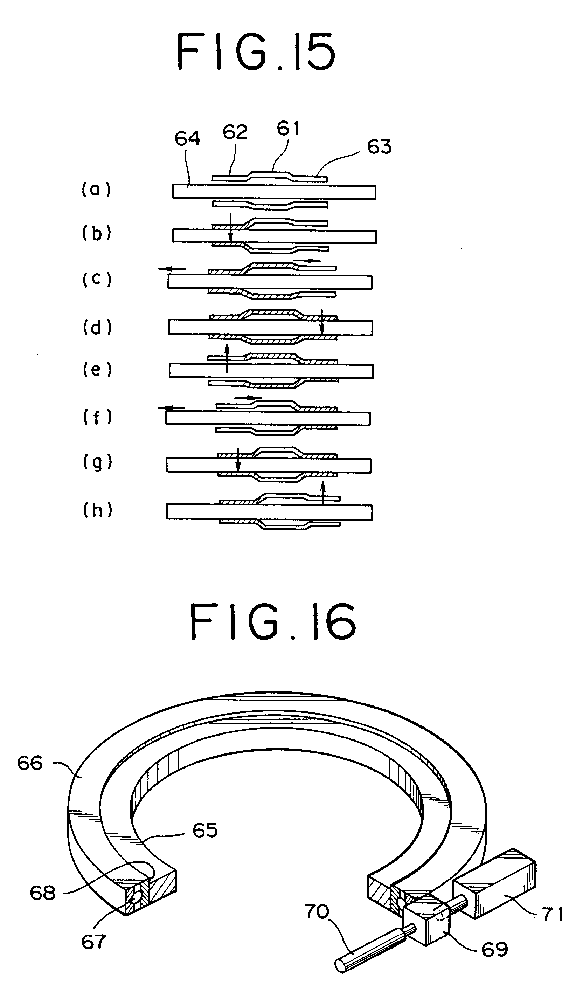

If the range of movement afforded by the piezoelectric devices 60 is too small, an alternative may be employed in an embodiment of the invention in which the range is enlarged by combining three piezoelectric devices so that they perform a measuring worm type motion as explained with reference to Fig. 15. That is, in Fig. 15, an expanding and contracting piezoelectric device 61 is sandwiched by clamping piezoelectric devices 62 and 63, and the central portion of the expanding and contracting piezoelectric device 61 is fixed to a fixed member not shown. Reference numeral 64 denotes a movable member. In Fig. 15, (a) shows a state where all piezoelectric devices are turned off. If the clamping piezoelectric device 62 is turned on as shown in (b) and then the expanding and contracting piezoelectric device 61 is expanded as shown in (c), as the expanding and contracting piezoelectric device 61 is fixed at its central portion, the movable member 64 is moved in the left-hand direction in the drawing. Then, if the clamping piezoelectric device 63 is turned on as shown in (d) and if the expanding and contracting piezoelectric device 61 is contracted as shown in (f) after the clamping piezoelectric device 62 is turned off as shown in (e), the movable member 64 is further moved in the left-hand direction because the central portion of the expanding and contracting piezoelectric device 61 is fixed. Then, if the clamping piezoelectric device 62 is turned on as shown in (g) and if the clamping piezoelectric device 63 is turned off as shown in (g), there can be obtained generally the same posture as shown in (b). Thereafter, by repeating each of the steps (b) to (h), the movable range of the movable member 64 can be enlarged by the measuring worm motion.

Referring to fig. 16, there is described a mechanism for providing the mask stage 14 with a degree of freedom in the B-axis direction (rotational direction). A ring-shaped fixed member 65 is attached to a ring-shaped movable member 66 through a ball bearing 67, and a step 68 is formed between the fixed member 65 and the movable member 66. The fixed member 56 shown in Fig. 12 is mounted on the ring-shaped movable member 66. By driving a projection 69 which is integral with the ring-shaped movable member 66 by means of a piezoelectric device 70, the ring-shaped movable member 66 can be rotated, and the degree of freedom in the ϑ-axis direction of the mask stage 14 can be provided. Reference numeral 71 denotes a position detector. In a case where the range of movement afforded by the piezoelectric device 70 is too small, three piezoelectric devices may be combined so as to perform the measuring worm type motion as indicated in Fig. 15.

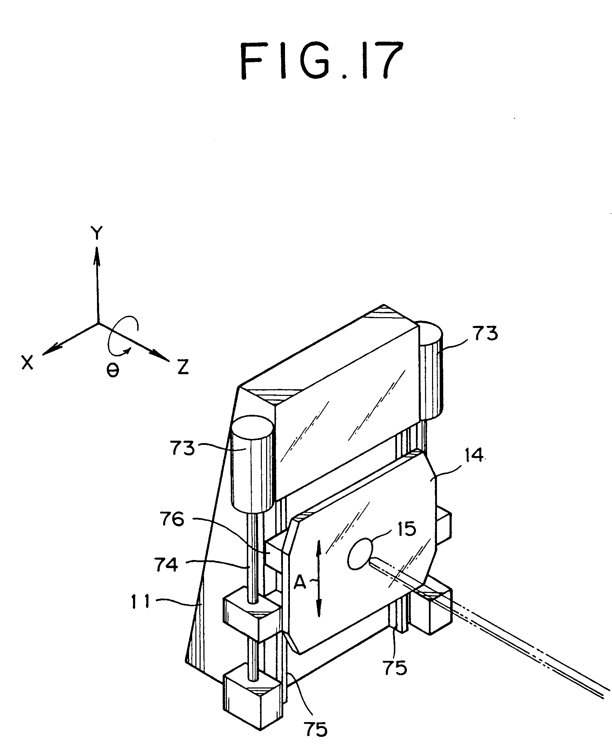

Referring to Fig. 17, there is described a scanning mechanism, for scanning with respect to the SR. While strictly maintaining the relative position between the mask 15, mounted on the mask stage 14, and the wafer (not shown), the mask stage 14 is scanned in perpendicular directions (directions as indicated by the arrow A) during SR exposure by a driving mechanism using a servo-motor 73 and a ball screw 74. As a guide mechanism during scanning, a pair of guide rails 75 are engaged with pair of linear guides 76 so that lateral movement of the mask stage 14 can be prevented during scanning. Positional detection with respect to the mask stage 14 during scanning can be performed by a rotary encoder directly connected with the servo-motor 73. Thus, by scanning the mask stage 14 integrally with the wafer in the perpendicular direction, SR can be irradiated on to the whole exposure area of the mask. As SR is generally formed of parallel rays, the pattern of the mask as transferred on to the wafer is generally as large as the original pattern on the mask.

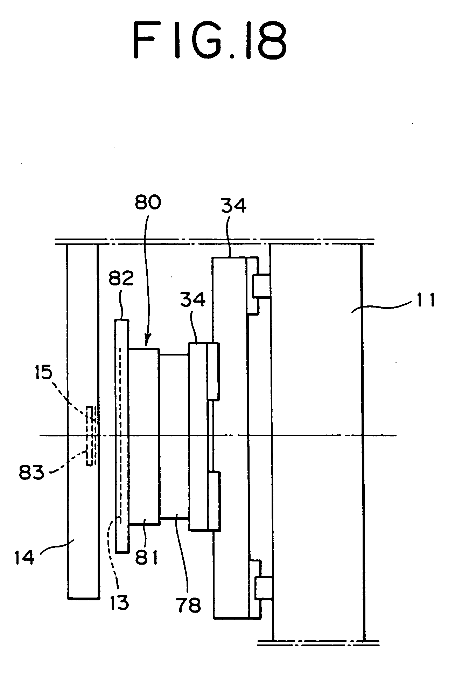

Next, referring to Figs. 18 to 21C, there will be described a wafer transfer mechanism of one embodiment of the present invention, for transferring a wafer from the wafer stage to the mask stage. In this embodiment, component parts generally as described above may be employed. Referring to Fig. 18, a transfer member 78 is mounted for lateral movement on the coarse X-Y stage 34. In turn, a wafer mounting member 80 is mounted on the transfer member 78 so that the wafer mounting member 80 can move between a first position mounted on the coarse X-Y stage 34 through the transfer member 78 and a second position separated from the transfer member 78 and attracted to the mask stage 14. The wafer mounting member 80 is provided with a fine X-Y stage 81, a wafer chuck (not shown) for vacuum drawing and fixing the wafer 13, and a suction portion 82 disposed on the outer periphery of the wafer chuck and adapted to be vacuum-drawn and fixed to the mask stage 14. Further, the mask 15 is removably attached to the mask stage 14 which is provided with a fine Z-ϑ stage 83 for moving the mask 15 in the direction of irradiation of SR and rotating the mask 15 in a plane perpendicular to the direction of irradiation of SR.

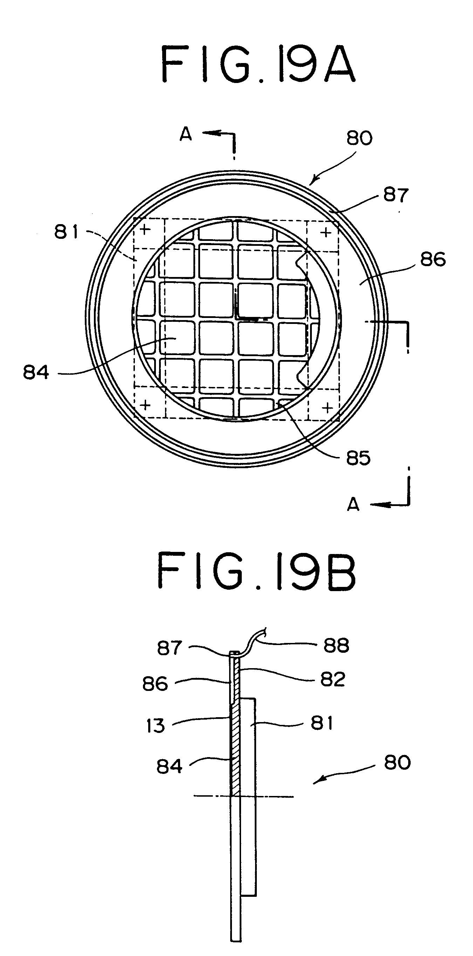

Referring to Figs. 19A and 19B, the wafer mounting member 80 will be described in detail. The wafer mounting member 80 is provided at its front side with a wafer chuck 84 having a suction groove 85 for fixing the wafer 13 by means of vacuum attraction and at its reverse side with a fine X-Y stage 81. A suction portion 82 disposed on the outer periphery of the wafer chuck 84 comprises an annular concave portion 86 and an annular suction groove 87. The annular suction groove 87 is connected with a vacuum suction means through a conduit 88.

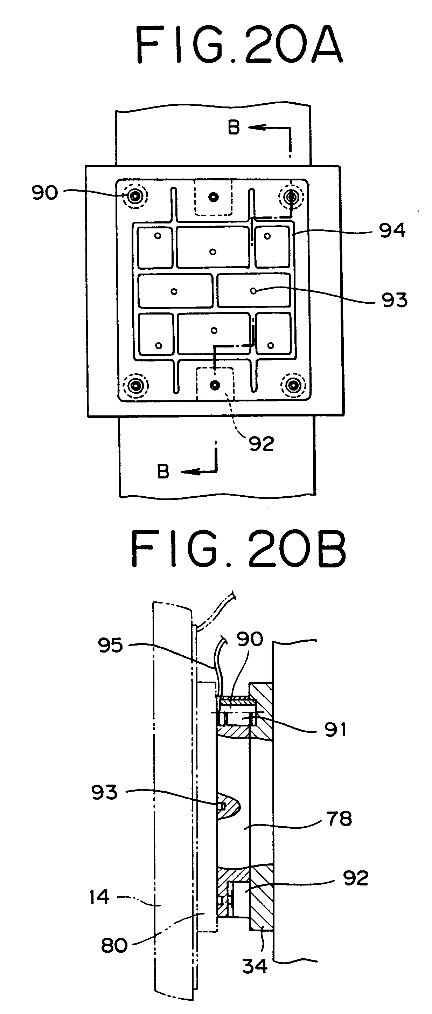

Figs 20A to 20B show the transfer mechanism in some detail, with a plurality of guide pins 90 attached to the coarse X-Y stage 34, which guide pins 90 are engaged with the transfer member 78 through linear ball bearings 91. Further, the coarse X-Y stage 34 is connected with one end of each of a pair of air cylinders 92, and the other ends of the air cylinders 92 are connected with the transfer member 78. Furthermore, the wafer mounting member 80 is provided with a plurality of position indexing plungers 93 which are air pressure operated. These plungers 93 are driven so as to be selectively engageable with the transfer member 78. Reference numeral 94 denotes a vacuum suction groove for drawing the wafer mounting member 80. The vacuum suction groove 94 is connected with a vacuum suction means through a conduit 95.

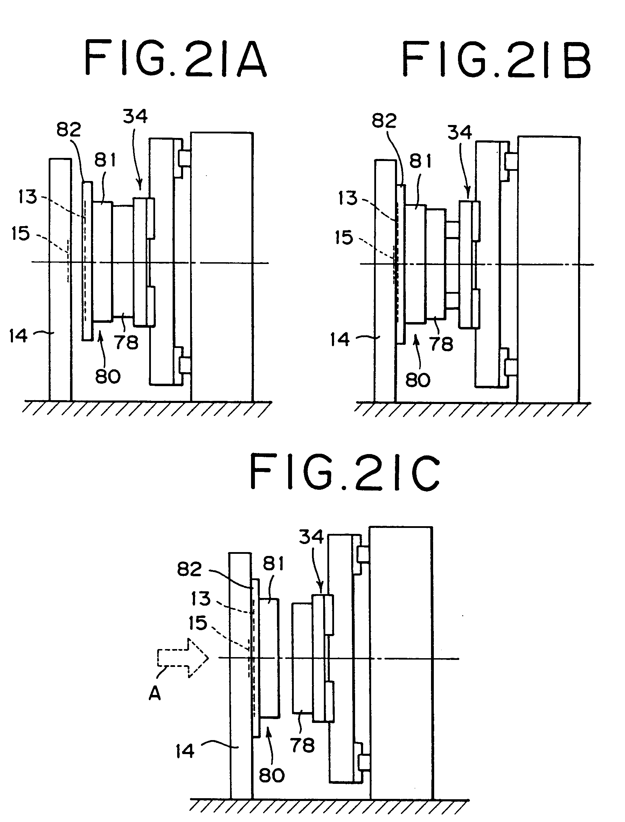

Next, referring to Figs. 21A to 21C, the operation of the transfer mechanism, and wafer exposure steps, will be described. The wafer stage 12 of this embodiment of the invention comprises the coarse X-Y stage 34, the transfer member 78, and the wafer mounting member 80 having the fine X-Y stage 81 mounted thereon. First, as shown in Fig. 21A, the coarse X-Y stage 34 is moved stepwise to correctly position a predetermined region of the wafer 13 with respect to the mask 15. At this time, the wafer mounting member 80 is vacuum-drawn to the transfer member 78. Upon driving of the air cylinders 92, the transfer member 78 slides in the left-hand direction guided by the guide pins 90 and the wafer mounting member 80 abuts against the reverse side of the mask stage 14 as shown in Fig. 21B. Then, as shown in Fig. 21C, after the wafer mounting member 80 is vacuum drawn to the mask stage 14 by the suction portion 82, the transfer member 78 releases the vacuum attraction to the wafer mounting member 80 and is retreated to return to the coarse X-Y stage 34.

In the state of Fig. 21C, after the wafer 13 and the mask 15 are accurately positioned by the fine X-Y stage 81 and the fine Z-ϑ stage 83, the mask stage 14 is moved for scanning in the vertical direction while irradiating SR in the direction as shown by an arrow A, so that the circuit pattern on the mask is transferred on to the wafer. During exposure, the wafer 13 and the mask 15 are not in intimate contact with each other but they are placed opposite each other with a very small space left therebetween.

According to the above-described embodiment of the invention, by virtue of the provision of the transfer member 78, the wafer mounting member 80 is not displaced by dead-weight in the perpendicular direction during transfer, and positioning work of the wafer and the mask can be efficiently performed.

Various possible changes and modifications of the described embodiments will occur to those skilled in the art.

For example, the above-described embodiments of the present invention concern vertical steppers wherein mask and wafer are oriented vertically. However, the present invention is not limited to vertical steppers: embodiments of the present invention may provide other types of stepper as long as wafer and mask are disposed in a direction perpendicular to the direction of irradiation of the exposure radiation. Embodiments of the present invention can provide steppers which, for instance, employ visible light or ultraviolet radiation for exposure.

In embodiments of the present invention, means used for attracting a wafer mounting member to a mask stage need not be suction means: other attracting means, such as magnetic attracting means, can be employed.

An embodiment of the present invention provides a stepper, for instance a vertical stepper, for transferring a circuit pattern formed on a mask on to a wafer using synchrotron radiation, for example, as a light source. The vertical stepper includes a wafer stage for mounting a wafer thereon in the vertical direction and a mask stage for mounting a mask thereon in the vertical direction. The wafer stage includes a coarse X-Y stage, a transfer member, and a wafer mounting member. The wafer mounting member is provided with a fine X-Y stage. The wafer mounting member is movable in a horizontal direction, between a first position mounted on the coarse X-Y stage and a second position mounted on the mask stage, by the transfer member. When exposed to the synchrotron radiation, the wafer mounting member is integrated with the mask stage and after the wafer and the mask are strictly correctly positioned by the fine X-Y stage, the wafer mounting member integral with the mask stage is moved for scanning in the vertical direction.

## Claims

1. A stepper for transferring a circuit pattern formed on a mask (15) on to a wafer (13) by means of exposure to radiation (SR) from a light source, for instance synchrotron radiation, said stepper comprising:-
a coarse X-Y stage (34) for moving the wafer (13) in a plane perpendicular to the direction of irradiation of said radiation;
a mask stage (14) for mounting the mask (15) thereon in such a manner that the mask (15) is oriented perpendicularly to the direction of irradiation of said radiation;
a wafer mounting member (80) for mounting the wafer (13) thereon in such a manner that the wafer (13) is oriented perpendicularly to the direction of irradiation of said radiation, said wafer mounting member (80) including fine X-Y positioning means (81);
characterised in that
the mask stage is adapted to be moved for scanning in a direction perpendicular to the direction of irradiation of said radiation;
the wafer mounting member is movable between a first position, mounted on said coarse X-Y stage (34), and a second position, mounted on said mask stage (14), and said fine X-Y positioning means is a fine X-Y positioning stage (81);
and in that the stepper further comprises
scanning means (73 to 75) for scanning said mask stage (14);
transfer means for moving said wafer mounting member (80) between said first and second positions;
first attracting means (84, 85) for attracting said wafer to said wafer mounting member (80); and
second attracting means (82, 87) for attracting said wafer mounting member (80) to said mask stage (14);
and in that
said mask stage (14) includes a fine Z-ϑ stage (83) for moving the mask (15) in the direction of irradiation of said radiation and rotating the mask (15) in a plane perpendicular to the direction of irradiation of said radiation.

2. A stepper as claimed in claim 1, wherein said transfer means includes a plurality of guide pins (90) mounted on said coarse X-Y stage (34), and air cylinder means (92) attached at one end to said coarse X-Y stage (34) and at the other end to said wafer mounting member (80), and said wafer mounting member (80) is engaged with and guided by said guide pins (90).

3. A stepper as claimed in claim 1 or 2, wherein said transfer means includes a transfer member (78), a plurality of guide pins (90) mounted on said coarse X-Y stage (34) and adapted to be engaged with said transfer member (78) in order to guide said transfer means; air cylinder means (92) attached at one end to said coarse X-Y stage (34) and at the other end to said transfer member (78); and third attracting means (94) for selectively attracting said wafer mounting member (80).

4. A stepper as claimed in claim 3, wherein a position indexing plunger (93) selectively engageable with said transfer member (78) is disposed on said wafer mounting member (80).

5. A stepper as claimed in any preceding claim, wherein said fine X-Y stage (81) comprises a fine X-axis stage (42) including a fine X-axis member (49) movable in the X-axis direction, first parallel plate spring guides (48) for supporting said fine X-axis member (49), and a first piezoelectric device (50) disposed in such a manner as to displace said fine X-axis member (49) in the X-axis direction; and a fine Y-axis stage (41) including a fine Y-axis member (45) movable in the Y-axis direction, second parallel plate spring guides (44) for supporting said fine Y-axis member (45), and a second piezoelectric device (46) disposed in such a manner as to displace said fine Y-axis member (45) in the Y-axis direction, said fine Y-axis stage being mounted on said fine X-axis stage.

6. A stepper as claimed in any of claims 1 to 4, wherein said fine X-Y stage (81) includes a fine X-Y member (52) movable in the X-axis and Y-axis directions; first, second, third and fourth parallel plate spring guide means (53a to 53d) for supporting said fine X-Y member (52); and first and second piezoelectric devices disposed in such a manner as to displace said fine X-Y member (52) in the X-axis and Y-axis directions, respectively.

7. A stepper as claimed in any preceding claim, further including first compensating means (25a to 25d, 36, 37) for compensating the dead weight of said coarse X-Y stage (34), and second compensating means for compensating the dead-weight of said mask stage (14) when moved for scanning.

8. A stepper as claimed in any preceding claim, wherein said first and second attracting means are suction means for vacuum drawing.

9. A stepper for transferring a circuit pattern formed on a mask (15) on to a wafer (13) by means of exposure to radiation (SR) from a light source, for instance synchrotron radiation, said stepper comprising:-
a coarse X-Y stage (34) for moving the wafer (13) stepwise in a plane perpendicular to the direction of irradiation of said radiation;
fine X-Y positioning means (35) mounted on the coarse X-Y stage (34) for moving the wafer (13) in a plane perpendicular to the direction of irradiation of said radiation;
a mask stage (14) for mounting the mask (15) thereon in such a manner that the mask (15) is oriented perpendicularly to the direction of irradiation of said radiation;
characterised in that
the mask stage (14) is adapted to be moved for scanning in a direction perpendicular to the direction of irradiation of said radiation;
the fine X-Y positioning means comprise a fine X-Y stage (35) having a fine X-axis stage (42) including a fine X-axis member (49) movable in the X-axis direction, first parallel plate spring guides (48) for supporting said fine X-axis member (49), and a first piezoelectric device (50) disposed in such a manner as to displace said fine X-axis member (49) in the X-axis direction; and a fine Y-axis stage (41) including a fine Y-axis member (45) movable in the Y-axis direction, second parallel plate spring guides (44) for supporting said fine Y-axis member (45), and a second piezoelectric device (46) disposed in such a manner as to displace said fine Y-axis member (45) in the Y-axis direction, said fine Y-axis stage being mounted on said fine X-axis stage;
in that the stepper further comprises
scanning means (73 to 75) for scanning said mask stage (14);
and in that
said mask stage (14) includes a fine Z-ϑ stage for moving the mask (15) in the direction of irradiation of said radiation and rotating the mask (15) in a plane perpendicular to the direction of irradiation of said radiation.

10. A stepper as claimed in claim 9, wherein said fine X-Y stage (35) includes a fine X-Y member (52) movable in the X-axis and Y-axis directions; first, second, third and fourth parallel plate spring guide means (53a to 53d) for supporting said fine X-Y member (52); and first and second piezoelectric devices disposed in such a manner as to displace said fine X-Y member (52) in the X-axis and Y-axis directions, respectively.

11. A stepper as claimed in claims 9 or 10, further including first compensating means (25a to 25d, 36, 37) for compensating the dead weight of said coarse X-Y stage (34) with the fine X-Y stage (35), and second compensating means for compensating the dead-weight of said mask stage (14) when moved for scanning.

12. A stepper as claimed in any preceding claim, being a vertical stepper.

13. A stepper as claimed in claim 12, for use with a synchrotron radiation light source from which radiation is emitted horizontally, with mask and wafer vertical in the stepper.

## Patentansprüche

1. Ein Stepper zum Übertragen eines Schaltungsmusters, das auf einer Maske (15) gebildet ist, auf einen Wafer (13), durch Belichtung mit einer Strahlung (SR) von einer Lichtquelle, zum Beispiel eine Synchrotronstrahlung, welcher Stepper umfaßt:-
eine X-Y-Grobstufe (34) zum Bewegen des Wafers (13) in einer Ebene senkrecht zu der Einstrahlungsrichtung der genannten Strahlung;
eine Maskenstufe (14) zum Daraufmontieren der Maske (15) auf solch eine Weise, daß die Maske (15) zu der Einstrahlungsrichtung der genannten Strahlung senkrecht ausgerichtet ist;
ein Wafermontierglied (80) zum Daraufmontieren des Wafers (13) auf solch eine Weise, daß der Wafer (13) zu der Einstrahlungsrichtung der genannten Strahlung senkrecht ausgerichtet ist, wobei das genannte Wafermontierglied (80) ein X-Y-Feinpositionierungsmittel (81) enthält;
dadurch gekennzeichnet, daß
die Maskenstufe dafür ausgelegt ist, um zum Scannen in einer Richtung senkrecht zu der Einstrahlungsrichtung der genannten Strahlung bewegt zu werden;
das Wafermontierglied zwischen einer ersten Position, montiert auf der genannten X-Y-Grobstufe (34), und einer zweiten Position, montiert auf der genannten Maskenstufe (14), beweglich ist, und das genannte X-Y-Feinpositionierungsmittel eine X-Y-Feinpositionierungsstufe (81) ist;
und daß der Stepper ferner umfaßt
Scanmittel (73 bis 75) zum Scannen der genannten Maskenstufe (14);
ein Transfermittel zum Bewegen des genannten Wafermontiergliedes (80) zwischen den genannten ersten und zweiten Positionen;
erste Anziehungsmittel (84, 85) zum Anziehen des genannten Wafers zu dem genannten Wafermontierglied (80); und
zweite Anziehungsmittel (82, 87) zum Anziehen des genannten Wafermontiergliedes (80) zu der genannten Maskenstufe (14);
und daß
die genannte Maskenstufe (14) eine Z-ϑ-Feinstufe (83) enthält, zum Bewegen der Maske (15) in der Einstrahlungsrichtung der genannten Strahlung und zum Rotieren der Maske (15) in einer Ebene senkrecht zu der Einstrahlungsrichtung der genannten Strahlung.

2. Ein Stepper nach Anspruch 1, bei dem das genannte Transfermittel eine Vielzahl von Führungsstiften (90) enthält, die auf der genannten X-Y-Grobstufe (34) montiert sind, und ein Luftzylindermittel (92), das an einem Ende mit der genannten X-Y-Grobstufe (34) und an dem anderen Ende mit dem genannten Wafermontierglied (80) verbunden ist, und das genannte Wafermontierglied (80) mit den genannten Führungsstiften (90) im Eingriff steht und durch sie geführt wird.

3. Ein Stepper nach Anspruch 1 oder 2, bei dem das genannte Transfermittel ein Transferglied (78) enthält, eine Vielzahl von Führungsstiften (90), die auf der genannten X-Y-Grobstufe (34) montiert sind und dafür ausgelegt sind, um mit dem genannten Transferglied (78) im Eingriff zu stehen, um das genannte Transfermittel zu führen; ein Luftzylindermittel (92), das an einem Ende mit der genannten X-Y-Grobstufe (34) und an dem anderen Ende mit dem genannten Transferglied (78) verbunden ist; und dritte Anziehungsmittel (94) zum selektiven Anziehen des genannten Wafermontiergliedes (80).

4. Ein Stepper nach Anspruch 3, bei dem ein Positionsindizierungskolben (93), der mit dem genannten Transferglied (78) selektiv im Eingriff stehen kann, auf dem genannten Wafermontierglied (80) angeordnet ist.

5. Ein Stepper nach einem der vorhergehenden Ansprüche, bei dem die genannte X-Y-Feinstufe (81) eine X-Achsen-Feinstufe (42) umfaßt, die ein X-Achsen-Feinglied (49) enthält, das in die Richtung der X-Achse beweglich ist, erste parallele Plattenfederführungen (48) zum Stützen des genannten X-Achsen-Feingliedes (49), und eine erste piezoelektrische Anordnung (50), die auf solch eine Weise angeordnet ist, um das genannte X-Achsen-Feinglied (49) in die Richtung der X-Achse zu versetzen; und eine Y-Achsen-Feinstufe (41), die ein Y-Achsen-Feinglied (45) enthält, das in die Richtung der Y-Achse beweglich ist, zweite parallele Plattenfederführungen (44) zum Stützen des genannten Y-Achsen-Feingliedes (45), und eine zweite piezoelektrische Anordnung (46), die auf solch eine Weise angeordnet ist, um das genannte Y-Achsen-Feinglied (45) in Richtung der Y-Achse zu versetzen, wobei die genannte Y-Achsen-Feinstufe auf der genannten X-Achsen-Feinstufe montiert ist.

6. Ein Stepper nach einem der Ansprüche 1 bis 4, bei dem die genannte X-Y-Feinstufe (81) ein X-Y-Feinglied (52) enthält, das in den Richtungen der X-Achse und der Y-Achse beweglich ist; erste, zweite, dritte und vierte parallele Plattenfederführungsmittel (53a bis 53d) zum Stützen des genannten X-Y-Feingliedes (52); und erste und zweite piezoelektrische Anordnungen, die auf solch eine Weise angeordnet sind, um das genannte X-Y-Feinglied (52) in den Richtungen der X-Achse bzw. der Y-Achse zu versetzen.

7. Ein Stepper nach einem der vorhergehenden Ansprüche, der ferner erste Kompensationsmittel (25a bis 25d, 36, 37) enthält, zum Kompensieren des Totgewichtes der genannten X-Y-Grobstufe (34), und zweite Kompensationsmittel zum Kompensieren des Totgewichtes der genannten Maskenstufe (14), wenn sie zum Scannen bewegt wird.

8. Ein Stepper nach einem der vorhergehenden Ansprüche, bei dem die genannten ersten und zweiten Anziehungsmittel Saugmittel zum Vakuumziehen sind.

9. Ein Stepper zum Übertragen eines Schaltungsmusters, das auf einer Maske (15) gebildet ist, auf einen Wafer (13), durch Belichtung mit einer Strahlung (SR) von einer Lichtquelle, zum Beispiel eine Synchrotronstrahlung, welcher Stepper umfaßt:-
eine X-Y-Grobstufe (34) zum schrittweisen Bewegen des Wafers (13) in einer Ebene senkrecht zu der Einstrahlungsrichtung der genannten Strahlung;
ein X-Y-Feinpositionierungsmittel (35), das auf der X-Y-Grobstufe (34) montiert ist, zum Bewegen des Wafers (13) in einer Ebene senkrecht zu der Einstrahlungsrichtung der genannten Strahlung;
eine Maskenstufe (14) zum Daraufmontieren der Maske (15) auf solch eine Weise, daß die Maske (15) zu der Einstrahlungsrichtung der genannten Strahlung senkrecht ausgerichtet ist;
dadurch gekennzeichnet, daß
die Maskenstufe (14) dafür ausgelegt ist, um zum Scannen in einer Richtung senkrecht zu der Einstrahlungsrichtung der genannten Strahlung bewegt zu werden;
das X-Y-Feinpositionierungsmittel eine X-Y-Feinstufe (35) umfaßt, die eine X-Achsen-Feinstufe (42) hat, die ein X-Achsen-Feinglied (49) enthält, das in der Richtung der X-Achse beweglich ist, erste parallele Plattenfederführungen (48) zum Stützen des genannten X-Achsen-Feingliedes (49), und eine erste piezoelektrische Anordnung (50), die auf solch eine Weise angeordnet ist, um das genannte X-Achsen-Feinglied (49) in Richtung der X-Achse zu versetzen; und eine Y-Achsen-Feinstufe (41), die ein Y-Achsen-Feinglied (45) enthält, das in der Richtung der Y-Achse beweglich ist, zweite parallele Plattenfederführungen (44) zum Stützen des genannten Y-Achsen-Feingliedes (45), und eine zweite piezoelektrische Anordnung (46), die auf solch eine Weise angeordnet ist, um das genannte Y-Achsen-Feinglied (45) in Richtung der Y-Achse zu versetzen, wobei die genannte Y-Achsen-Feinstufe auf der genannten X-Achsen-Feinstufe montiert ist;
daß der Stepper ferner
Scanmittel (73 bis 75) zum Scannen der genannten Maskenstufe (14) umfaßt;
und daß
die genannte Maskenstufe (14) eine Z-ϑ-Feinstufe enthält, zum Bewegen der Maske (15) in der Einstrahlungsrichtung der genannten Strahlung und zum Rotieren der Maske (15) in einer Ebene senkrecht zu der Einstrahlungsrichtung der genannten Strahlung.

10. Ein Stepper nach Anspruch 9, bei dem die genannte X-Y-Feinstufe (35) ein X-Y-Feinglied (52) enthält, das in den Richtungen der X-Achse und der Y-Achse beweglich ist; erste, zweite, dritte und vierte parallele Plattenfederführungsmittel (53a bis 53d) zum Stützen des genannten X-Y-Feingliedes (52); und erste und zweite piezoelektrische Anordnungen, die auf solch eine Weise angeordnet sind, um das genannte X-Y-Feinglied (52) in den Richtungen der X-Achse bzw. der Y-Achse zu versetzen.

11. Ein Stepper nach Anspruch 9 oder 10, der ferner erste Kompensationsmittel (25a bis 25d, 36, 37) zum Kompensieren des Totgewichtes der genannten X-Y-Grobstufe (34) mit der X-Y-Feinstufe (35) enthält, und zweite Kompensationsmittel zum Kompensieren des Totgewichtes der genannten Maskenstufe (14), wenn sie zum Scannen bewegt wird.

12. Ein Stepper nach einem der vorhergehenden Ansprüche, der er vertikaler Stepper ist.

13. Ein Stepper nach Anspruch 12, zum Einsatz mit einer Synchrotronstrahlungslichtquelle, von der die Strahlung horizontal ausgesendet wird, wobei die Maske und der Wafer in dem Stepper vertikal angeordnet sind.

## Revendications

1. Dispositif de gravure répétiteur, destiné à transférer un motif de circuit, formé sur un masque (15), sur une pastille (13) par exposition à un rayonnement (SR) provenant d'une source de lumière, par exemple un rayonnement synchrotron, ledit dispositif de gravure répétiteur comprenant :
un plateau à déplacement micrométrique X-Y grossier (34) servant à déplacer la pastille (13) dans un plan perpendiculaire à la direction d'irradiation par ledit rayonnement ;
un porte-masque (14) servant à monter le masque (15) de manière que ce dernier soit orienté perpendiculairement à la direction d'irradiation par ledit rayonnement ;
un élément de montage de pastille (80) servant à monter la pastille (13) de manière que cette dernière soit orientée perpendiculairement à la direction d'irradiation par ledit rayonnement, ledit élément de montage de pastille (80) comportant un moyen de positionnement X-Y fin (81) ;
caractérisé en ce que :
le porte-masque est destiné à être déplacé en vue d'un balayage suivant une direction perpendiculaire à la direction d'irradiation par ledit rayonnement ;
l'élément de montage de pastille est mobile entre une première position, de montage sur ledit plateau à déplacement micrométrique X-Y grossier (34), et une deuxième position, de montage sur ledit porte-masque (14), et ledit moyen de positionnement X-Y fin est un plateau à déplacement micrométrique de positionnement X-Y fin (81) ;
en ce que ledit dispositif de gravure répétiteur comprend en outre :
un moyen de balayage (73 à 75) servant à balayer ledit porte-masque (14) ;
un moyen de transfert servant à déplacer ledit élément de montage de pastille (80) entre lesdites première et deuxième positions ;
un premier moyen d'attraction (84, 85) servant à attirer ladite pastille jusque sur ledit élément de montage de pastille (80) ; et
un deuxième moyen d'attraction (82, 87) servant à attirer ledit élément de montage de pastille (80) jusque sur ledit porte-masque (14) ;
et en ce que :
ledit porte-masque (14) comporte un plateau à déplacement micrométrique Z-ϑ fin (83) servant à déplacer le masque (15) dans la direction d'irradiation par ledit rayonnement et à faire tourner le masque (15) dans un plan perpendiculaire à la direction d'irradiation par ledit rayonnement.

2. Elément de gravure répétiteur selon la revendication 1, où ledit moyen de transfert comporte une pluralité de tiges de guidage (90) montées sur ledit plateau à déplacement micrométrique X-Y grossier (34), et un moyen formant un cylindre pneumatique (92) fixé par une extrémité audit plateau à déplacement micrométrique X-Y grossier (34) et, par son autre extrémité, audit élément de montage de pastille (80), et ledit élément de montage de pastille (80) est en prise avec lesdites tiges de guidage (90) et est guidé par ces dernières.

3. Dispositif de gravure répétiteur selon la revendication 1 ou 2, où ledit moyen de transfert comporte un élément de transfert (78), une pluralité de tiges de guidage (90) montées sur ledit plateau à déplacement micrométrique X-Y grossier (34) et destinées à venir en prise avec ledit élément de transfert (78) afin de guider ledit moyen de transfert ; un moyen formant un cylindre pneumatique (92) fixé par une extrémité audit plateau à déplacement micrométrique X-Y grossier (34) et, par son autre extrémité, audit élément de transfert (78) ; et un troisième moyen d'attraction (94) servant à sélectivement attirer ledit élément de montage de pastille (80).

4. Dispositif de gravure répétiteur selon la revendication 3, où un plongeur de repérage de position (93), qui peut sélectivement venir en contact avec ledit élément de transfert (78), est disposé sur ledit élément de montage de pastille (80).

5. Dispositif de gravure répétiteur selon l'une quelconque des revendications précédentes, où ledit plateau à déplacement micrométrique X-Y fin (81) comprend un plateau à déplacement micrométrique d'axe X fin (42) comportant un élément d'axe X fin (49) mobile suivant la direction de l'axe X, des premiers guides élastiques en forme de lames parallèles (48) servant à soutenir ledit élément d'axe X fin (49), et un premier dispositif piézo-électrique (50) disposé de manière à déplacer ledit élément d'axe X fin (49) suivant la direction de l'axe X ; et un plateau à déplacement micrométrique d'axe Y fin (41) comportant un élément d'axe Y fin (45) mobile suivant la direction de l'axe Y, des deuxièmes guides élastiques en forme de lames parallèles (44) servant à soutenir ledit élément d'axe Y fin (45), et un deuxième dispositif piézo-électrique (46) disposé de manière à déplacer ledit élément d'axe Y fin (45) suivant la direction de l'axe Y, ledit plateau à déplacement micrométrique d'axe Y fin étant monté sur ledit plateau à déplacement micrométrique d'axe X fin.

6. Dispositif de gravure répétiteur selon l'une quelconque des revendications 1 à 4, où ledit plateau à déplacement micrométrique X-Y fin (81) comporte un élément X-Y fin (52) mobile suivant la direction de l'axe X et celle de l'axe Y; des premier, deuxième, troisième et quatrième moyens de guidage élastiques en forme de lames parallèles (53a à 53d) servant à soutenir ledit élément X-Y fin (52); et des premier et deuxième dispositifs piézo-électriques disposés de manière à déplacer ledit élément X-Y fin (52) respectivement suivant les directions d'axe X et d'axe Y.

7. Dispositif de gravure répétiteur selon l'une quelconque des revendications précédentes, comportant en outre un premier moyen de compensation (25a à 25d, 36, 37) servant à compenser le poids mort dudit plateau à déplacement micrométrique X-Y grossier (34), et un deuxième moyen de compensation servant à compenser le poids mort dudit porte-masque (14) lors des déplacements associés au balayage.

8. Dispositif de gravure répétiteur selon l'une quelconque des revendications précédentes, où lesdits premier et deuxième moyens d'attraction sont des moyens d'aspiration permettant d'effectuer une traction sous vide.

9. Dispositif de gravure répétiteur, destiné à transférer un motif de circuit, formé sur un masque (15), sur une pastille (13) par exposition à un rayonnement (SR) venant d'une source de lumière, par exemple un rayonnement synchrotron, ledit dispositif de gravure répétiteur comprenant :
un plateau à déplacement micrométrique X-Y grossier (34) servant à déplacer la pastille (13) pas à pas dans un plan perpendiculaire à la direction d'irradiation par ledit rayonnement ;
un moyen de positionnement X-Y fin (35) monté sur le plateau à déplacement micrométrique X-Y grossier (34) et servant à déplacer la pastille (13) dans un plan perpendiculaire à la direction d'irradiation par ledit rayonnement ;
un porte-masque (14) servant à monter le masque (15) de manière que ce dernier soit orienté perpendiculairement à la direction d'irradiation par ledit rayonnement ;
caractérisé en ce que :
le porte-masque (14) est destiné à être dépacé en vue d'un balayage dans une direction perpendiculaire à la direction d'irradiation par ledit rayonnement ;
le moyen de positionnement X-Y fin comprend un plateau à déplacement micrométrique X-Y fin (35) qui possède un plateau à déplacement micrométrique d'axe X fin (42) comportant un élément d'axe X fin (49) mobile suivant la direction de l'axe X, des premiers guides élastiques en forme de lames parallèles (48) servant à soutenir ledit élément d'axe X fin (49), et un premier dispositif piézo-électrique (50) disposé de manière à déplacer ledit élément d'axe X fin (49) suivant la direction de l'axe X ; et un plateau à déplacement micrométrique d'axe Y fin (41) comportant un élément d'axe Y fin (45) mobile suivant la direction de l'axe Y, des deuxièmes guides élastiques en forme de lames parallèles (44) servant à soutenir ledit élément d'axe Y fin (45), et un deuxième dispositif piézo-électrique (46) disposé de manière à déplacer ledit élément d'axe Y fin (45) suivant la direction de l'axe Y, ledit plateau à déplacement micrométrique d'axe Y fin étant monté sur ledit plateau à déplacement micrométrique d'axe X fin ;
en ce que le dispositif de gravure répétiteur comprend en outre :
un moyen de balayage (73 à 75) servant à balayer ledit porte-masque (14) ;
et en ce que :
ledit porte-masque (14) comporte un plateau à déplacement micrométrique Z-ϑ fin servant à déplacer le masque (15) dans la direction d'irradiation par ledit rayonnement et à faire tourner le masque (15) dans un plan perpendiculaire à la direction d'irradiation par ledit rayonnement.

10. Dispositif de gravure répétiteur selon la revendication 9, où ledit plateau à déplacement micrométrique X-Y fin (35) comporte un élément X-Y fin (52) mobile dans la direction de l'axe X et dans celle de l'axe Y ; des premier, deuxième, troisième et quatrième moyens de guidage élastiques en forme de lames parallèles (53a à 53d) servant à soutenir ledit élément X-Y fin (52) ; et des premier et deuxième dispositifs piézo-électriques disposés de manière a déplacer ledit élément X-Y fin (52) respectivement dans la direction de l'axe X et dans celle de l'axe Y.

11. Dispositif de gravure répétiteur selon la revendication 9 ou 10, comportant en outre un premier moyen de compensation (25a à 25d, 36, 37) servant à compenser le poids mort dudit plateau à déplacement micrométrique X-Y grossier (34) avec ledit plateau à déplacement micrométrique X-Y fin (35), et un deuxième moyen de compensation servant à compenser le poids mort dudit porte-masque (14) lors des déplacements associés au balayage.

12. Dispositif de gravure répétiteur selon l'une quelconque des revendications précédentes, qui est un dispositif de gravure répétiteur vertical.

13. Dispositif de gravure répétiteur selon la revendication 12, qui est destiné à être utilisé avec une source de lumière du type rayonnement synchrotron, depuis laquelle le rayonnement est émis horizontalement, le masque et la pastille étant disposés verticalement dans le dispositif de gravure répétiteur.
